# EUROPÄISCHE PATENTANMELDUNG

(11) **EP 1 077 380 A2**
(43) Veröffentlichungstag der Anmeldung: **21.02.2001**
(21) Anmeldenummer: 00117665.0
(22) Anmeldetag: 16.08.2000
(51) Int. Cl.: G01R 31/00

(54) **Vorrichtung und Verfahren zur Messung von Netzrückwirkungen inbesondere von Bahnfahrzeugen**

(30) Priorität: 18.08.1999 DE 19939222
(71) Anmelder: SIEMENS AKTIENGESELLSCHAFT, 80333 München (DE)
(72) Erfinder: Schellhaus, Stefan, Dipl.-Ing., 91058 Erlangen (DE); Zimmer, Gerhard, Dr., 91054 Buckenhof (DE)

(57) **Zusammenfassung**

Die Erfindung betrifft eine Vorrichtung und ein Verfahren zur Messung von Netzrückwirkungen insbesondere von elektrischen Antrieben (3) von Bahnfahrzeugen (10). Für eine möglichst fehler- und verzerrungsfreie Messung wird vorgeschlagen, eine Rogowski-Spule (1) ohne Integrator zu verwenden, die niederimpedant abgeschlossen wird. Durch die mit einem niederimpedanten Abschluß (2) versehene Rogowski-Spule (1) entsteht ein sehr lineares Meßsystem, das in Dynamik und Aussteuerbarkeit nicht begrenzt ist und ein geringes Eigenrauschen aufweist.

## Beschreibung

Die Erfindung betrifft eine Vorrichtung und ein Verfahren zur Messung von Netzrückwirkungen insbesondere von elektrischen Antrieben von Bahnfahrzeugen.

Zur Überprüfung der elektromagnetischen Verträglichkeit von elektrischen Antrieben, insbesondere von Umrichtern und Motoren sind Messungen von Netzrückwirkungen erforderlich. So müssen auch bei Bahnfahrzeugen entsprechende Netzrückwirkungen, beispielsweise im Frequenzbereich von 10 Hz bis 100 kKz gemessen werden.

Aus der DE-A 42 04 515 ist ein Verfahren zum Messen von Strömen in Energieversorgungsnetzen der Hoch- bzw. Mittelspannung mit einer Rogowski-Spule bekannt. Hierzu wird der Rogowski-Spule ein digitaler Integrator mit dynamischer Umschaltung der Eingangsempfindlichkeit zur Verarbeitung der Messsignale verwendet.

Der Erfindung liegt die Aufgabe zugrunde, eine Vorrichtung und ein Verfahren zur Messung von Netzrückwirkungen anzugeben, das auf einfache Weise eine möglichst fehlerfreie und verzerrungsfreie Messung von Störströmen ermöglicht.

Diese Aufgabe wird durch eine Vorrichtung zur Messung von Netzrückwirkungen, insbesondere von elektrischen Antrieben von Bahnfahrzeugen gelöst, mit einer Rogowski-Spule ohne Integrator, wobei die Rogowski-Spule zur induktiven Kopplung mit einer Netzspannung vorgesehen ist, wobei die Rogowski-Spule mit einem niederimpedanten Abschluß abgeschlossen ist und wobei eine Spannung am Abschluß zur direkten Verarbeitung durch eine Aufzeichnungs- und/oder Weiterverarbeitungseinheit vorgesehen ist.

Diese Aufgabe wird durch ein Verfahren zur Messung von Netzrückwirkungen, insbesondere von elektrischen Antrieben von Bahnfahrzeugen gelöst, mit einer Rogowski-Spule ohne Integrator, bei dem die Rogowski-Spule mit einer Netzspannung induktiv gekoppelt wird, bei dem die Rogowski-Spule mit einem niederimpedanten Abschluß abgeschlossen wird und bei dem eine Spannung am Abschluß direkt Verarbeitung durch eine Aufzeichnungs- und/oder Weiterverarbeitungseinheit weiterverarbeitet wird.

Bei einer derartigen Vorrichtung wird somit lediglich eine Rogowski-Spule ohne Integrator verwendet, die niederimpedant abgeschlossen wird. Die Spannung am niederimpedanten Abschluß wird dabei **direkt** von einem Aufzeichnungs- und/oder Weiterverarbeitungssystem verarbeitet. Die Vorrichtung zur Messung der Netzrückwirkungen bestehend aus der Rogowski-Spule und dem niederimpedanten Abschluß ist vom physikalischen Prinzip her absolut linear, in Dynamik und Aussteuerbarkeit nicht begrenzt und hat ein extrem geringes Eigenrauschen. Der Frequenzgang dieses Systems führt zu einer Dynamikkompression ohne Informationsverlust. Somit werden niedrige Frequenzen, die mit höherer Amplitude im zu messenden Strom vorhanden sind niedriger abgebildet, während höhere Frequenzen mit geringerer Amplitude vorhanden sind besser abgebildet werden. Das Meß- und Aufzeichnungssystem kann somit entweder mit einer geringeren Dynamik als bisherige Systeme arbeiten oder bei gleicher Dynamik der Aufzeichnungs- und/oder Verarbeitungsvorrichtung zu messende Signale mit höherer Dynamik verarbeiten. Der niederimpedante Abschluß reduziert außerdem in erheblichem Maße kapazitive Störeinkopplungen auf die Rogowski-Spule sowie auf deren Zuleitungen.

Eine Weiterverarbeitung der Meßsignale kann vorteilhafter Weie dadurch erfolgen, daß die Rogowski-Spule mit niederimpedantem Abschluß zum Anschluß an eine als Datenrekorder ausgebildete Aufzeichnungs- und/oder Weiterverarbeitungseinheit vorgesehen ist.

Bei einer bevorzugten Ausgestaltungsform ist die Spannung am Abschluß zur Bearbeitung mit linearen Operationen, insbesondere Hochpaß-, Tiefpaß-, Bandpaßfilterung, Addition, Subtraktion, FFT und Integration vorgesehen. Dies wird insbesondere durch die Linearität der Rogowski-Spule ohne Integrator ohne Abschluß sichergestellt.

Als vorteilhafte Dimensionierungsgrößen für den Abschluß der Rogowski-Spule hat es sich erwiesen, daß der Betrag der Abschlußimpedanz einen Wert von 10 bis 100 Ohm aufweist.

Im folgenden wird die Erfindung anhand des in der Figur dargestellten Ausführungsbeispiels näher beschrieben und erläuert.

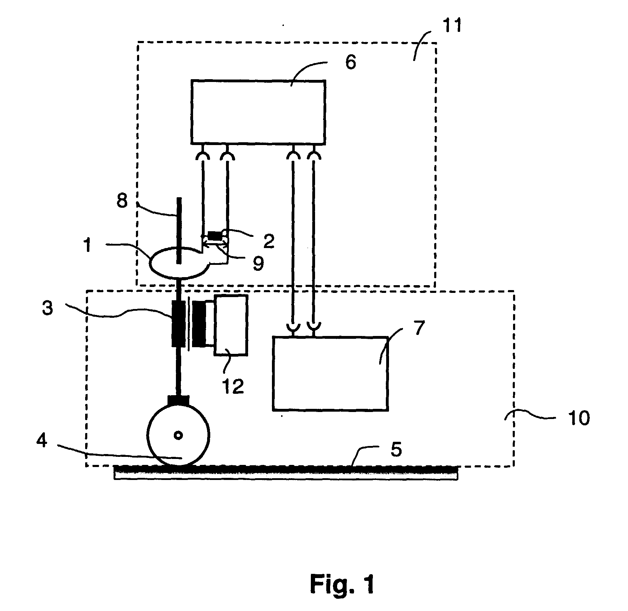

Figur 1 zeigt ein Blockschaltbild einer Prinzipdarstellung eines Meßsystems mit einer über einen niederimpedanten Widerstand abgeschlossenen Rogowski-Spule.

Figur 1 zeigt ein Meßsystem 11 welches zur Messung von Störströmen eines Bahnfahrzeugs 10 vorgesehen ist. Die Prinzipdarstellung des Bahnfahrzeuges 10 besteht aus einem Rad 4, einer Antriebseinheit 3 mit gekoppeltem Umrichter 12, wobei das Bahnfahrzeug 10 auf einer Schiene 5 angeordnet ist. Die weiteren Komponenten des Bahnfahrzeugs 10 sind aus Gründen der Übersichtlichkeit in der Figur nicht näher dargestellt. Das Meßsystem 11 besteht aus einer Rogowski-Spule 1, die um eine einen Netzstrom 8 führende Netzleitung zur Speisung der Antriebseinheit 3 des Bahnfahrzeugs 10, angeordnet ist. Die Rogowski-Spule 1 weist einen niederimpedanten Abschluß 2, insbesondere einen niederohmigen Abschlußwiderstand auf, an dem eine Meßspannung 9 abgreifbar ist. Die Meßspannung 9 wird einer Aufzeichnungs- und/oder Weiterverarbeitungseinheit 6 in Form eines Datenrekorders weitergeleitet. Dem Datenrekorder 6 werden darüber hinaus weitere Orientierungsgrößen, beispielsweise Drehzahl etc. einer Einheit 7 des Bahnfahrzeugs 10 zugeführt.

Das in der Figur dargestellte Meßsystem 11 eignet sich insbesondere zur Messung von Netzrückwirkungen speziell bei Bahnfahrzeugen bzw. allgemein bei Umrichtern an Netzen im Frequenzbereich von ca. 10 Hz bis 100 kHz. Dabei sollen von Umrichtern, beispielsweise von der Antriebseinheit 3 erzeugte Störströme im Bereich von einigen Milliampere bis einigen Ampere bei gleichzeitigen Nutzströmen zwischen 1000 Ampere bei Wechselstromsystemen (16 2/3 Hz oder 50 Hz) und 4000 A bei Gleichstromsystemen möglichst fehlerfrei und verzerrungsfrei gemessen werden. Die Besonderheit des Meßsystems 11 bei den in der Figur dargestellten Ausführungsbeispiel besteht darin, daß die Rogowski-Spule 1 ohne Integrator verbunden wird, vielmehr wird die Rogowski-Spule 1 lediglich über einen niederimpedanten Abschluß 2 niederimpedant abgeschlossen. Die Spannung 9 am Abschlußwiderstand 2 wird direkt vom Datenrekorder 6 weiterverarbeitet. Das System Rogowski-Spule 1 und ohmscher Widerstand 2 verhält vom physikalischen Prinzip her absolut linear, es ist in Dynamik und Aussteuerbarkeit nicht begrenzt und weist ein extrem geringes Eigenrauschen auf. Der Frequenzgang dieses Systems Rogowski-Spule plus niederimpedanter Abschluß 2 führt zu einer Dynamikkompression ohne Informationsverlust. Dabei werden niedrige Frequenzen, die mit höherer Amplitude im zu messenden Strom vorhanden sind niedriger abgebildet, während höhere Frequenzen, die mit geringerer Amplitude vorhanden sind besser abgebildet werden. Das Meß- und Aufzeichnungssystem, d.h. der Datenrekorder 6 kann somit entweder mit einer geringeren Dynamik als bisherige Systeme arbeiten oder bei gleicher Dynamik zu messende Signale mit höherer Dynamik verarbeiten. Die Linearität der Rogowski-Spule 1 ohne Integrator mit Abschluß 2 gewährleistet weiter, daß die gemessenen Größen mit allen linearen Operationen, insbesondere Hochpaß-, Tiefpaß-, Bandpaßfilterung, Addition, Subtraktion, schneller Fouriertransformation FFT, Integration etc. bearbeitet werden können. Der niederimpedante Abschluß 2 reduziert außerdem in erheblichem Maße kapazitive Störeinkopplungen auf die Rogowski-Spule 1 sowie auf deren Zuleitungen.

Zusammenfassend betrifft die Erfindung somit eine Vorrichtung und ein Verfahren zur Messung von Netzrückwirkungen insbesondere von elektrischen Antrieben 3 von Bahnfahrzeugen 10. Für eine möglichst fehler- und verzerrungsfreie Messung wird vorgeschlagen, eine Rogowski-Spule 1 ohne Integrator zu verwenden, die niederimpedant abgeschlossen wird. Durch die mit einem niederimpedanten Abschluß 2 versehene Rogowski-Spule 1 entsteht ein sehr lineares Meßsystem, das in Dynamik und Aussteuerbarkeit nicht begrenzt ist und ein geringes Eigenrauschen aufweist.

## Patentansprüche

1. Vorrichtung zur Messung von Netzrückwirkungen, insbesondere von elektrischen Antrieben (3) von Bahnfahrzeugen, mit einer Rogowski-Spule (1) ohne Integrator,
• wobei die Rogowski-Spule (1) zur induktiven Kopplung mit einem Netzstrom (8) vorgesehen ist,
• wobei die Rogowski-Spule (1) mit einem niederimpedanten Abschluß (2) abgeschlossen ist und
• wobei eine Spannung (9) am niederimpedanten Abschluß (2) zur direkten Verarbeitung durch eine Aufzeichnungs- und/oder weiterverarbeitungseinheit (6) vorgesehen ist.

2. Vorrichtung nach Anspruch 1,
**dadurch gekennzeichnet**,
daß der niederimpedante Abschluß (2) als niederohmiger Abschlußwiderstand ausgebildet ist.

3. Vorrichtung nach einem der Ansprüche 1 oder 2,
**dadurch gekennzeichnet**,
daß die Rogowski-Spule (1) mit niederimpedantem Abschluß (2) zum Anschluß an eine als Datenrekorder ausgebildete Aufzeichnungs- und/oder Weiterverarbeitungseinheit (6) vorgesehen ist.

4. Vorrichtung nach einem der Ansprüche 1 bis 3,
**dadurch gekennzeichnet**,
daß die Spannung (9) am Abschluß (2) zur Bearbeitung mit linearen Operationen, insbesondere Hochpaß-, Tiefpaß-, Bandpaßfilterung, Addition, Subtraktion, FFT und Integration vorgesehen ist.

5. Vorrichtung nach einem der Ansprüche 1 bis 4,
**dadurch gekennzeichnet**,
daß der Betrag des Abschluß (2) einen Wert von 10 bis 100 Ohm aufweist.

6. Verfahren zur Messung von Netzrückwirkungen, insbesondere von elektrischen Antrieben (3) von Bahnfahrzeugen, mit einer Rogowski-Spule (1) ohne Integrator, bei dem die Rogowski-Spule (1) mit einem Netzstrom (8) induktiv gekoppelt wird, bei dem die Rogowski-Spule (1) mit einem niederimpedanten Abschluß (2) abgeschlossen wird und bei dem eine Spannung (9) am niederimpedanten Abschluß (2) direkt Verarbeitung durch eine Aufzeichnungs- und/oder Weiterverarbeitungseinheit (6) weiterverarbeitet wird.

7. Verfahren nach Anspruch 6,
**dadurch gekennzeichnet**,
daß als niederimpedanter Abschluß (2) ein niederohmiger widerstand verwendet wird.

8. Verfahren nach einem der Ansprüche 6 oder 7,
**dadurch gekennzeichnet**,
daß die Spannung (9) am niederimpedantem Abschluß (2) von einer als Datenrekorder ausgebildete Aufzeichnungs- und/oder Weiterverarbeitungseinheit (6) weiterverarbeitet wird.

9. Verfahren nach einem der Ansprüche 6 bis 8,
**dadurch gekennzeichnet**,
daß die Spannung (9) am Abschluß (2) zur Bearbeitung mit linearen Operationen, insbesondere Hochpaß-, Tiefpaß-, Bandpaßfilterung, Addition, Subtraktion, FFT und Integration vorgesehen ist.

10. Verfahren nach einem der Ansprüche 6 bis 9,
**dadurch gekennzeichnet**,
daß als Abschluß (2) ein niederimpedanter Abschluß mit einem Betragswert von 10 bis 100 Ohm verwendet wird.
